# EUROPÄISCHE PATENTSCHRIFT

(11) **EP 2 356 667 B1**
(45) Veröffentlichungstag und Bekanntmachung des Hinweises auf die Patenterteilung: **12.02.2014**
(21) Anmeldenummer: 09771700.3
(22) Anmeldetag: 17.11.2009
(51) Int. Cl.: H01H 19/00, H01H 19/02, H01H 19/03, H01H 19/58, G04C 23/10

(54) **ELEKTRISCHES KLEMMENMODUL**
ELECTRICAL TERMINAL MODULE
MODULE DE BORNE ÉLECTRIQUE

(30) Priorität: 17.11.2008 DE 102008057748
(43) Veröffentlichungstag der Anmeldung: 17.08.2011
(73) Patentinhaber: Phoenix Contact GmbH & Co. KG, 32823 Blomberg (DE)
(72) Erfinder: HAKEMEYER, Frank, 32805 Horn-Bad Meinberg (DE); STARKE, Christian, 32657 Lemgo (DE); KLEINSCHMIDT, Jürgen, 32760 Detmold (DE)
(86) Internationale Anmeldenummer: PCT/EP2009/008182
(87) Internationale Veröffentlichungsnummer: WO 2010/054854

(56) Entgegenhaltungen:
- DE-C1- 4 308 242
- US-A- 4 395 610
- US-A- 5 570 777

## Beschreibung

Die Erfindung betrifft ein elektrisches Klemmenmodul mit einer Vielzahl von elektrischen Kontaktelementen zum Anschluss elektrischer Leiter, einem Gehäuse zur Aufnahme zumindest einer Leiterplatte, auf der eine Schaltungsanordnung mit elektrischen Bauelementen zur Ausführung einer vorbestimmten Funktion, insbesondere einer Zeitschaltfunktion, angeordnet sind und Verstellmitteln zur Veränderung zumindest einer elektrischen Kenngröße der Schaltungsanordnung, wobei zumindest ein Teil des Verstellmittels durch eine Öffnung in zumindest einer Seitenwand des Gehäuses bedienbar und von außen verschwenkbar oder verdrehbar ist.

Elektrische Klemmenmodule der gattungsgemäßen Art werden vorwiegend mit weiteren elektrischen und/oder elektronischen Klemmenmodulen in Schaltschränken eingebaut. Die Befestigung der elektrischen Klemmenmodule im Schaltschrank erfolgt üblicherweise durch Aufrasten auf einer Hutschiene, wobei sie vorzugsweise direkt nebeneinander angeordnet werden. Um Kosten zu sparen, sind die Betreiber von Maschinen und Anlagen bemüht, den zur Verfügung stehenden Schaltschrankplatz möglichst optimal auszunutzen und die Anzahl der aufzustellenden Schaltschränke so weit wie möglich zu reduzieren.

Die Hersteller elektrischer Klemmenmodule folgen diesem Trend und bieten den Betreibern von Maschinen und Anlagen vermehrt elektrische Klemmenmodule an, die eine immer schmalere Baubreite aufweisen und von denen in einem Schaltschrank eine immer größere Anzahl eingebaut werden können. So sind am Markt inzwischen Klemmenmodule mit einer Baubreite von weniger als 8 mm bekannt. Die Verringerung der Baubreite der elektrischen Klemmenmodule hat zur Folge, dass auch der zur Verfügung stehende Raum für den Einbau von bestückten Leiterplatten weiter abnimmt. Bei einem elektrischen Klemmenmodul mit einer Baubreite von weniger als 8 mm kommt neben der Dicke einer in das elektrische Klemmenmodul eingebauten Leiterplatte auch die Bauhöhe der auf der Leiterplatte aufgebrachten elektronischen Bauteile ein immer höheres Gewicht zu.

Viele der genannten elektrischen Klemmenmodule stellen den Anwendern Möglichkeiten zur Verfügung, von außerhalb des Gehäuses Einstellungen vornehmen zu können, um damit eine elektrische Funktion des Klemmenmoduls wie z. B. eine Zeitfunktion einstellen bzw. verändern zu können. So ist es bei derartigen elektrischen Klemmenmodule möglich, die Zeit, nach der beispielsweise in einer Anwendung ein Schaltvorgang ausgelöst werden soll, einstellen zu können. Unter der Verstellung einer Funktion des elektrischen Klemmenmoduls soll auch das Einstellen und/oder Verstellen eines elektrischen und/oder physikalischen Parameters der Funktion des elektrischen Klemmenmoduls verstanden werden. Bei weiteren elektrischen Funktionen und/oder Parametern, die eingestellt werden können, kann es sich beispielsweise auch um Stromwerte, Spannungswerte, Widerstandswerte, Wertebereiche von Eingangs- und/oder Ausgangsgrößen, Verstärkungsfaktoren, Verzögerungszeiten, Betriebsarten und dergleichen handeln. Insbesondere bei sicherheitstechnischen Anwendungen bieten die gattungsgemäßen elektrischen Klemmenmodule sicherheitsrelevante Funktionen wie z. B. das Einstellen einer maximal erlaubten Drehzahl für eine sicher reduzierte Geschwindigkeit eines an das elektrische Klemmenmodul angeschlossenen Motors an. Ferner kann es sich bei den weiteren Funktionen auch um die Einstellung von Frequenzen auszugebener Signale, die ein- oder mehrkanalige Verarbeitung von an das elektrische Klemmenmodul angeschlossenen Eingangssignale, die Auswahl von Muting-Funktionen und/oder Schutzbereichen, die Einstellung sicherer Betriebsarten oder anderer sicherheitstechnischer Funktionen handeln.

Zur Veränderung der Funktion eines elektrischen Klemmenmoduls werden oftmals verstellbare Potentiometer, Kondensatoren, Induktivitäten, Betriebsartenwahlschalter oder dergleichen verwendet. Es sind aber auch Bauteile bekannt, bei denen die Einstellung der Funktion des elektrischen Klemmenmoduls berührungslos z. B. mittels optischer und/oder induktiver Erfassung des Verstellweges oder der Erfassung einer aktuellen relativen und/oder absoluten Stellung des Verstellmittels erfolgt. Solche Bauteile werden üblicherweise auf einer Bestückungsseite einer Leiterplatte angeordnet.

Die Verstellmittel selbst sind in erster Linie als mechanische Schalter, Einstellräder, Hebel, Taster oder dergleichen ausgeführt. Demzufolge ist nicht nur ein Drehen sondern auch ein Schwenken oder Schalten des Verstellmittels möglich.

Aufgrund des in elektrischen Klemmenmodulen der gattungsgemäßen Art begrenzt zur Verfügung stehenden Einbauraums, kommen vorwiegend elektrische Bauteile in SMD-Technik zum Einsatz, die ohne Anschlussdrähte direkt auf der Leiterplatte aufgebracht und verlötet werden. Da solche Bauteile zumindest auf einer Seite einer Leiterplatte angeordnet sind, erfolgt deren Verstellung senkrecht zur Leiterplattenoberfläche.

Bei elektrischen Klemmenmodulen mit Baubreiten von unter 8 mm, vorzugsweise kleiner oder gleich 6,2 mm, ist bekannt, zur Verstellung der auf der Leiterplatte aufgebrachten Bauelemente eine Öffnung in einer Seite der Klemmenmodule zu vorzusehen. Die Verstellung der elektrisch verstellbaren Bauelementen erfolgt dabei durch Einführen eines Schraubendrehers durch die in der Seitenfläche des elektrischen Klemmenmoduls geschaffenen Öffnung in eine in dem elektrischen Bauteil zur Verstellung seiner elektrischen Kenngröße vorgesehenen Öffnung, die zur Aufnahme beispielsweise einer Schraubendreherspitze ausgebildet ist. Bei der beschriebenen Anordnung des verstellbaren elektrischen Bauteils ist die Verstellung nur von einer Seite des Klemmenmoduls möglich. Eine Verstellung ist regelmäßig aber dann nicht mehr möglich, wenn mehrere elektrische Klemmenmodule direkt nebeneinander angeordnet sind.

Eine andere Lösung besteht darin, unter einem Deckel eines elektrischen Klemmenmoduls eine Leiterplatte vorzusehen, auf der das verstellbare elektrische Bauteil angeordnet ist. Die Verstellung des Bauteils erfolgt in diesem Fall mit Hilfe eines Schraubendrehers durch eine Öffnung durch den Deckel hindurch. Eine solche Realisierung ist jedoch dann nicht möglich, wenn für das Bauteil und die zusätzliche Leiterplatte in dem Gehäuse durch die begrenzte Baubreite des elektrischen Klemmenmoduls nicht mehr ausreichend Raum zur Verfügung steht. Bei Baubreiten unter 8 mm ist eine derartige Lösung nicht mehr praktikabel. Darüber hinaus muss für die Montage eines solchen Klemmenmoduls eine zusätzliche Leiterplatte und bei der Bestückung des Klemmenmoduls ein weiterer Arbeitsschritt vorgesehen werden. Beides führt zu unerwünschten Erhöhung der Herstellkosten.

Ferner ist zu beachten, dass die Lötstellen der elektrischen Bauteile in SMD-Technik, kaum in der Lage sind, die Kräfte, die bei der Verstellung z. B. unter Zuhilfenahme eines Schraubendrehers auftreten, ausreichend absorbieren zu können. So kann es schnell dazu kommen, dass die Bauteile überdreht oder sogar ganz von der Leiterplatte abgerissen werden.

Aufgrund der geringen Baubreite der elektrischen Klemmenmodule ist es somit am vorteilhaftesten, die verstellbaren elektrischen Bauteile auf der in das elektrische Klemmenmodul eingebauten Leiterplatte anzuordnen und eine Verstellung auch dann zu ermöglichen, wenn mehrere elektrischen Klemmenmodule in eingebautem Zustand nebeneinander, insbesondere auf einer Hutschiene, angeordnet sind.

Aus dem Stand der Technik ist bekannt, auf den verstellbaren elektrischen Bauteilen ein Rad anzubringen, dessen Rand über die Vorderseite des elektrischen Klemmenmoduls teilweise heraus ragt und von außen bedienbar ist. Die Positionierung des Bauteils erfolgt in der Nähe des Randes einer Leiterplatte.

Dabei ist allerdings nachteilig, dass die genannten elektrischen Bauteile wie Potentiometer, verstellbare Kondensatoren und dergleichen als kompakte, nach außen abgeschlossene Bauelemente aufgebaut sind, die für ein Verlöten auf einer Leiterplatte nach außen Lötfahnen oder Anschlussbeinchen aufweisen, mit denen sie auf der Leiterplatte angeordnet werden. Darüber hinaus sind solche Bauteile mit zahlreichen, in mehreren Lagen aufeinander angeordneten Einzelelementen aufgebaut, die zusammen in einem eigens dafür vorgesehenen Gehäuse eingebaut sind.

Die Befestigung von SMD-Bauteilen auf einer Leiterplatte erfolgt üblicherweise durch Verlöten zumindest eines Randes des Bauteilgehäuses mit Kontaktstellen auf der Leiterplatte. Damit muss hinsichtlich der zur Verfügung stehenden Baubreite neben der Dicke der Leiterplatte zusätzlich noch die Bauhöhe des elektrischen Bauteils berücksichtigt werden.

Bekannte Potentiometer beispielsweise sind so aufgebaut, dass auf einem Trägermaterial Widerstandsschichten und zumindest eine Abgriffsbahn angeordnet sind, auf die ein Abnehmer zugreift, der zwischen beiden eine elektrische Verbindung herstellt. Die gesamte Anordnung ist in einem eigenen Gehäuse eingebaut. Bei dieser Art von Potentiometer wird auf das Bauteil zusätzlich ein Rad befestigt, mit dem sich beispielsweise ein Widerstandswert eines Potentiometers verstellen lässt. Gleiches trifft in analoger Weise auch zu für andere verstellbare elektrische Bauteile wie z. B. verstellbare Kondensatoren wie Drehkondensatoren und/oder Trimmer, verstellbare Induktivitäten aber auch für verstellbare elektrische Bauteile, bei denen die Veränderung der Stellung des Rades auf optischem, induktivem und/oder kapazitivem Weg ermittelt wird.

Durch das nachträgliche Anordnen eines Rades auf das verstellbare elektrische Bauteil werden zudem die Anschlusspunkte auf der Leiterplatte überdeckt, so dass die Kontrolle der Qualität der Lötstellen kaum oder gar nicht mehr möglich ist. Dies erschwert im Falle fehlerhafter Lötstellen die Fehlersuche erheblich. Ferner ist die Temperatur beim Verlöten des Potentiometers mit aufgesetztem Rad so groß, dass das üblicherweise aus Kunststoff bestehende Rad beschädigt würde. Da die Bauhöhe eines solchen Potentiometers bereits sehr hoch ist, bliebe für den Rand des Rades nicht mehr viel Raum übrig, was die Verstellung des Rades erschwert. Auch kann keine Bedruckung des Randes mehr vorgenommen werden.

Alle genannten elektrischen Bauelemente weisen bereits von sich aus eine Bauhöhe auf, die mit dem Aufbringen eines Rades und der Dicke der Leiterplatte den zur Verfügung stehenden Platz in elektrischen Klemmenmodulen mit einer Baubreite deutlich unter acht Millimeter teilweise deutlich überschreitet.

Aus der DE 1921230 A ist ein Potentiometer bekannt, bei dem mehrere Widerstandsschichten auf einer Isolierplatte aufgebracht sind. Auf einer Achse ist ein Schleifer befestigt, wobei die Achse in einem Bund drehbar gelagert ist, der seinerseits in einer Bohrung der Isolierplatte gehalten wird. Die Verstellung des Widerstandswertes des Potentiometers erfolgt über Verstellung der Achse, an die ein Schleifer befestigt ist und an deren einen Ende ein Schlitz zur Aufnahme einer Schraubendreherspitze vorgesehen ist. Zusätzlich sind zumindest zwei Unterlegscheiben vorgesehen, die zusammen mit der Dicke der Isolierplatte die Bauhöhe des Potentiometers weiter erhöhen. Auf der Isolierplatte sind keine weiteren elektrischen Bauelemente angeordnet. Die Verbindung des beschriebenen Potentiometers mit weiteren Bauteilen auf einer Leiterplatte erfolgt über Lötfahnen mit Befestigungs- und/oder Lötlöchern, so dass die bei der Verstellung des Potentiometers auftretenden Kräfte allein durch die Lötfahnen an die Leiterplatte abgeleitet werden müssen.

Aus der DE 2521789A1 ist ein Potentiometer oder Schiebewiderstand bekannt, der vorzugsweise als Einzelbaustein zur unmittelbaren, integralen Verbindung mit einer weiteren Schaltungselemente tragenden Leiterplatte vorgesehen ist. Hierzu sind auf der Leiterplattenoberfläche Widerstandsschichten aufgebracht, auf die ein Abgriff zugreift, der eine Abgriffsbahn mit Widerstandsgleitbahnen verbindet. Durch Verschieben des Abgriffs ist der Widerstandswert des Potentiometers veränderbar. Da die Leiterplatte durchbrochen ist, ist zur Führung und Befestigung des Bauteils auf und/oder in dem Schaltungsträger ein Lagerteil und ein Gleit- oder Halteteil vorgesehen. Diese sind auf beiden Seiten der durchbrochenen Leiterplatte angeordnet. Das Lagerteil und das Gleit- oder Halteteil beiderseits der Leiterplattenoberfläche erhöhen die Bauhöhe des Potentiometers so, dass ein Einbau in elektrische Klemmenmodule der gattungsgemäßen Art nicht mehr möglich ist.

Ein elektrisches Klemmenmodul, das bereits eine Leiterplatte mit einem verstellbaren elektrischen Bauteil enthält, ist ferner aus der DE 43 08 242 C1 bekannt. Das verstellbare elektrische Bauteil auf dem Schaltungsträger, die Leiterplatten mit der entsprechenden Schaltung, das zur Versteilung des auf dem Schaltungsträger angeordneten, verstellbaren elektrischen Bauteils vorgesehene Rändelrad und die jeweiligen Deckel werden vor dem Einbau miteinander verbunden und anschließend in das Gehäuse eingesetzt. Die Bauhöhe des mit dem verstellbaren elektrischen Bauteil verbundenen Rändelrads ist auch bei dieser Lösung noch zu der Bauhöhe des verstellbaren elektrischen Bauteils hinzuzurechnen. Eine Verwendung in einem elektrischen Klemmenmodul mit einer noch schmaleren Baubreite bis unter acht Millimeter ist ebenfalls nicht mehr möglich.

Der Erfindung liegt daher die Aufgabe zugrunde, ein elektrisches Klemmenmodul anzugeben, dessen vorbestimmte Funktion veränderbar ist, wobei noch schmalere Gehäusebreiten ermöglicht, eine komfortable Bedienbarkeit erhalten und die Nachteile des Standes der Technik vermieden werden.

Die erfindungsgemäße Lösung der Aufgabe wird durch die Merkmale des unabhängigen Anspruchs wiedergegeben. Vorteilhafte und/oder bevorzugte Ausführungsformen bzw. Weiterbildungen sind Gegenstand der jeweiligen abhängigen Unteransprüche.

Erfindungsgemäß ist somit vorgesehen, dass das Verstellmittel durch ein Lager unmittelbar auf der Leiterplatte gelagert ist.

Durch die unmittelbare Lagerung des Verstellmittels auf der Leiterplatte wird einerseits erreicht, dass die Baubreite des elektrischen Klemmenmoduls deutlich reduziert werden kann. Die Baubreite des elektrischen Klemmenmoduls wird lediglich durch die Breite des Verstellmittels und der Dicke der Leiterplatte bestimmt. Die durch eine Verstellung des Verstellmittels auftretenden Kräfte werden direkt an die Leiterplatte abgeleitet und nicht von den Anschlusspunkte des elektrischen Bauteils aufgenommen, wodurch eine stabilere Befestigung des elektrischen Bauteils auf der Leiterplatte erreicht wird.

Eine bevorzugte Ausgestaltung des erfindungsgemäßen elektrischen Klemmenmoduls sieht vor, dass die Lagerung des Verstellmittels durch Vernieten und/oder Verrasten des Verstellmittels im Lager auf der Leiterplatte erfolgt.

Hierdurch wird der Vorteil erreicht, dass für die Befestigung des Verstellmittels keine zusätzlichen Halte- und/oder Lagermittel vorgesehen werden müssen, die zu der Bauhöhe des verstellbaren elektrischen Bauteils hinzugerechnet werden müssten. Ferner werden die bei der Verstellung des Verstellmittels auftretenden Kräfte direkt an die Leiterplatte weiter geleitet und müssen nicht von Lötanschlüssen oder dergleichen absorbiert werden. Ein unbeabsichtigtes Abreißen des elektrischen Bauteils wird somit weitgehendst verhindert.

Durch die schmale Bauform des elektrischen Klemmenmoduls kann zusätzlich oder alternativ auf der dem Verstellmittel gegenüberliegenden Gehäuseinnenseite ein Gehäuseteil angeordnet sein, dass so an die Gehäuseinnenseite angeformt ist, dass es das Verstellmittel zwischen sich aufnimmt. Die bei der Verstellung auftretenden Kräfte werden durch das Gehäuseteil zusätzlich an das Gehäuse abgeleitet, so dass eine noch höhere Stabilität des Verstellmittels auf der Leiterplatte erreicht wird.

Eine bevorzugte Ausgestaltung des erfindungsgemäßen elektrischen Klemmenmoduls sieht vor, dass auf der Leiterplatte Mittel zur Abstützung des Verstellmittels auf der Leiterplatte vorgesehen sind.

Über die zusätzliche Abstützung am äußeren Rand des Verstellmittels werden die bei der Verstellung des Verstellmittels auftretenden Kräfte noch besser an die Leiterplatte weitergeleitet und eine noch höhere mechanische Stabilität erreicht.

In einer bevorzugten Ausgestaltung ist ferner vorgesehen, dass die Mittel zur Abstützung des Verstellmittels auf der Leiterplatte durch eine auf der Leiterplatte angeordnete Gleitbahn gebildet werden, deren Geometrie zumindest teilweise mit der Geometrie des Verstellmittels korrespondiert.

Durch die mit der Geometrie der Verstellvorrichtung übereinstimmenden Anordnung der Gleitbahn auf der Leiterplatte wird einerseits erreicht, dass die bei der Verstellung auftretenden Kräfte zusätzlich an die Leiterplatte abgeleitet werden. Andererseits wird durch die Gleitbahn verhindert, dass die bei der Verstellung auftretende Reibung auf der Leiterplattenoberfläche die Leiterplatte beschädigt werden kann. Darüber hinaus kann die zusätzliche Gleitbahn auch als Vorwiderstand für elektrische Bauteile wie beispielsweise Dioden oder als Widerstand innerhalb der Schaltungsanordnung verwendet werden.

Als besonders bevorzugte Weiterbildung der Erfindung ist vorgesehen, dass auf der der Leiterplattenoberfläche zugewandten Fläche des Verstellmittels Elemente vorgesehen sind, die mit auf und/oder innerhalb der Leiterplatte angeordneten Gegenelemente so zusammen wirken, dass zwischen ihnen bei Zuführung einer Spannung eine elektrische Kenngröße gebildet wird.

Dadurch, dass das verstellbare elektrische Bauteil durch miteinander zusammenwirkenden Elemente und Gegenelemente gebildet wird, von denen ein Element auf einer Fläche des Verstellmittels und das Gegenelement auf oder innerhalb der Leiterplatte angeordnet ist, ist ein verstellbares elektrisches Bauteil entstanden. Die unmittelbare Lagerung des Verstellmittels im Lager auf der Leiterplatte bewirkt einen kompakten, raumsparenden Aufbau des verstellbaren elektrischen Bauteils, so dass die Bauhöhe des so gebildeten verstellbaren elektrischen Bauteils im Wesentlichen nur noch durch die Breite des Verstellmittels selbst bestimmt wird. Die Bauhöhe des verstellbaren elektrischen Bauteils ist damit so weit reduziert worden, dass es auch in elektrischen Klemmenmodulen in "Schmalbauweise" mit einer Baubreite von weniger als acht Millimeter verwendbar ist.

Eine weitere Ausführungsform der Erfindung sieht vor, dass die zwischen den Elementen des Verstellmittels und den Gegenelementen auf und/oder innerhalb der Leiterplatte gebildete Kenngröße ein elektrischer Widerstand, eine Kapazität und/oder eine Induktivität ist.

Hierdurch wird eine geringere Bauhöhe des verstellbaren elektrischen Bauteils erreicht, wodurch seine Verwendung mit anderen auf der Schaltungsanordnung angeordneten elektrischen Bauteilen in elektrischen Klemmenmodulen mit einer Baubreite unter acht Millimeter möglich geworden ist. Besonders vorteilhaft ist, dass die verwendeten Elemente und Gegenelemente im Wesentlichen zwischen der Fläche der Leiterplatte und der Fläche des der Leiterplatte gegenüber liegenden Verstellmittels angeordnet sind. Der Rand des Verstellmittels kann das gesamte verstellbare elektrische Bauteil umfassen und somit von Umwelteinflüssen abschirmen.

Derselbe Vorteil stellt sich ein, wenn die Elemente und Gegenelemente so angeordnet sind, dass unterschiedliche Strompfade einstellbar sind und eine optische, kapazitive und/oder induktive Erfassung einer relativen und/oder absoluten Stellung des Verstellmittels auf der Leiterplatte erfolgt. Die berührungslose Erfassung der Stellung des Verstellmittels vermeidet zusätzlich den Verschleiß und/oder Abnutzungserscheinungen der Elemente und Gegenelemente des verstellbaren elektrischen Bauteils.

Durch den Aufbau des verstellbaren elektrischen Bauteils mit Elementen, die sowohl auf dem Verstellmittel als auch auf der Leiterplatte angeordnet sind, werden die Baumaße des elektrischen Bauteils so weit reduziert, dass sie mit der Leiterplatte in elektrische Klemmenmodule in "Schmalbauweise" mit einer Baubreite unter acht Millimeter eingesetzt werden können, wobei eine einfache, komfortable Verstellbarkeit der Funktion des elektrischen Klemmenmoduls erhalten bleibt.

Bevorzugt ist weiter vorgesehen, dass zwischen auf der der Leiterplatte zugewandten Kante des Verstellmittels und dazu korrespondierend auf der Leiterplatte weitere Elemente angeordnet sind, die so zusammen wirken, dass zwischen ihnen bei Zuführung einer Spannung eine zweite elektrische Kenngröße gebildet wird.

Durch Anordnung von zusätzlichen Elementen wie Leiterbahnabschnitte, Abnehmer oder dergleichen auf der Kante des der Leiterplattenoberfläche zuwandten Seite des Verstellmittels und dazu korrespondierend auf der Leiterplattenoberfläche angeordneten zusätzlichen Gegenelementen wird mit derselben Anordnung von Verstellmittel und Leiterplatte der Vorteil erreicht, dass eine zweite elektrische Kenngröße gebildet werden kann.

Eine weitere Ausführungsform der Erfindung sieht vor, dass auf und/oder innerhalb der Leiterplatte Verrastungsmittel des Verstellmittels in vorbestimmten Abständen angeordnet sind.

Durch die Verrastungsmittel wird erreicht, dass einem Bediener bei der Einstellung der elektrischen Kenngröße vordefinierte Einstellpositionen angeboten werden, die ihm eine exaktere Einstellung von vordefinierten Zwischenwerten der elektrischen Kenngröße ermöglicht.

Ferner ist vorgesehen, dass das Verstellmittel aus einem transparenten und/oder lichtdurchlässigen Material besteht und dass auf und/oder in der Leiterplatte Mittel zur Beleuchtung des Verstellmittels vorgesehen sind.

Da die elektrischen Klemmenmodule sowohl innerhalb als auch außerhalb von Schaltschränken eingesetzt werden können und die Markierungen aufgrund schlechter Lichtverhältnisse und/oder bei Dunkelheit kaum oder gar nicht ablesbar sein können, ermöglicht die Verwendung eines transparenten und/oder lichtdurchlässigen Materials für das Verstellmittel und die Anordnung von Beleuchtungsmitteln unter oder neben dem Verstellmittel eine einfache Ablesbarkeit des eingestellten Werts bzw. der eingestellten Position des Verstellmittels innerhalb des elektrischen Klemmenmoduls. Ein noch besseres Ablesen wird erreicht, wenn die Farbe der Markierungen und die Farbe des Materials des Verstellmittels zueinander einen starken Kontrast, beispielsweise bei Verwendung eines weißen, lichtdurchlässigen Kunststoffs für das Verstellmittel und eine schwarze Farbe für die Markierungen, aufweisen.

Eine weitere Ausführungsform sieht vor, dass das Verstellmittel vorzugsweise als Rad ausgebildet ist, auf dessen äußeren Umfang Markierungen vorgesehen sind, die eine Einstellung der elektrischen Kenngröße in vorgegebenen Schritten ermöglichen, wobei die Markierungen einen logischen Bezug zu der jeweils mittels des Verstellmittels eingestellten elektrischen Kenngröße aufweisen können.

Durch die Markierungen wird erreicht, dass vordefinierte Werte wie z. B. ein Schaltzeitverzögerung von fünf Sekunden oder ein auszugebender Strom von fünf Milliampere einfach und intuitiv dadurch einstellbar sind, dass die entsprechende Markierung z. B. in Form der Ziffer Fünf in die Öffnung des Gehäuses gedreht wird. So ist es auf einfache Weise möglich, einen bestimmten als Markierung aufgebrachten Wert wie beispielsweise eine Abschaltzeit von fünf Sekunden einzustellen, nach der das elektrische Klemmenmodul einen zugehörigen Schaltvorgang auslösen soll. Der Bediener bekommt aufgrund der eingestellten Markierung eine Information über den tatsächlich eingestellten physikalischen Wert und kann ihn dadurch von außerhalb des elektrischen Klemmenmoduls einfacher und intuitiver einstellen und ablesen. Der logische Bezug besteht demnach darin, die Markierungen so vorzusehen, dass sie mit einzustellenden elektrischen und/oder physikalischen Werten der Funktion des elektrischen Klemmenmoduls korrespondieren und/oder einfach zu assoziieren sind. Sind zusätzlich Verrastungsmittel vorgesehen, so ist ein wesentlich leichteres, komfortableres und genaueres Einstellen der elektrischen Kenngröße des verstellbaren elektrischen Bauteils und damit der Funktion des elektrischen Klemmenmoduls möglich.

Eine weitere Ausführungsform sieht vor, dass auf der Leiterplatte Anschläge zur Festlegung einer Anfangs- und/oder Endstellung des Verstellmittels angeordnet sind.

Hierdurch wird ein Überdrehen des Verstellmittels verhindert und das elektrische Bauteil vor mechanischer Zerstörung geschützt. Der Bediener bekommt eine deutliche Rückmeldung, wenn eine Anfangs- und/oder Endstellung des verstellbaren elektrischen Bauteils erreicht worden ist.

Besonders bevorzugt ist vorgesehen, dass das Verstellmittel mit seiner Verstellmittelkante sowohl die Elemente auf dem Verstellmittel als auch die auf der Leiterplatte angeordneten Gegenelemente vollständig umfasst.

Durch das vollständige Umfassen des verstellbaren elektrischen Bauteils durch die Kante des Verstellmittels wird einerseits ein kompakter Aufbau des Bauteils erreicht und das Bauteil mit seinen Elementen und Gegenelementen von schädlichen Umwelteinflüssen abgeschirmt. Darüber hinaus lässt sich die Bauhöhe des Verstellmittels in der Gehäuseöffnung des elektrischen Klemmenmoduls maximieren, so dass sowohl die Fläche zum Aufbringen der Markierungen am Rand des Verstellmittels vergrößert als auch die Bedienbarkeit des Verstellmittels im elektrischen Klemmenmodul verbessert wird.

Bevorzugt ist ferner vorgesehen, dass die Baubreite des Gehäuses höchsten acht Millimeter beträgt und/oder höchsten eineinhalb mal so groß ist wie die Höhe des Verstellmittels.

Durch die unmittelbare Lagerung des Verstellmittels im Lager auf der Leiterplatte wird erreicht, dass die Leiterplatte mit den verstellbaren elektrischen Bauelementen in einem Gehäuse eingebaut werden kann, dessen Baubreite kleiner als acht Millimeter, vorzugsweise kleiner oder gleich 6,2 mm ist.

Bei elektrischen Klemmenmodulen von z. B. nur 6,2 mm Baubreite liegt die . Bauhöhe des Verstellmittels typischerweise bei nur in etwa vier Millimetern. Bei verstellbaren elektrischen Bauelemente aus dem Stand der Technik, die lediglich ein Einstellrad aufgesteckt bekommen, würde die Baubreite deutlich unter vier Millimeter liegen, so dass insbesondere das Aufbringen von Markierungen und/oder eine einfache Einstellung bei solch schmalen elektrischen Klemmenmodulen nicht mehr möglich wäre.

In einer weiteren bevorzugten Ausführungsform ist vorgesehen, auf der zum Verstellmittel gegenüberliegenden Seite der Leiterplatte ein zweites Verstellmittel anzuordnen, wodurch der Vorteil erreicht wird, dass bei Verwendung von mehr als einer Einstellvorrichtung der Platzbedarf für eine zusätzliche Leiterplatte eingespart und der vorhandene Einbauraum noch besser ausgenutzt werden kann. Dadurch, dass die gegenüber angeordneten Einstellvorrichtungen jeweils einen Teil der Leiterplatte zwischen sich aufnehmen, können auf einer einzigen Leiterplatte mehrere Einstellvorrichtungen angeordnet werden.

In vorteilhafter Weise ist ferner vorgesehen, die beiden Verstellmittel gemeinsam durch das Lager auf den jeweils gegenüberliegenden Seiten der Leiterplatte zu lagern. Über die bessere Ausnutzung des Einbauraums hinaus wird hierdurch zusätzlich erreicht, dass die Verstellmittel gemeinsam durch eine Öffnung in zumindest einer Seitenwand des Gehäuses auf gleicher Höhe durch ein und dieselbe Öffnung der Gehäusewand hindurch bedienbar sind. Werden beide Verstellmittel über das gemeinsame Lager miteinander gekoppelt, ist auch eine simultane Verstellung mehrerer elektrischer Kenngrößen der Schaltungsanordnung möglich.

Es versteht sich von selbst, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Bezugszeichenliste

1: Gehäuse
2: Verstellmittel
3: Kontaktelement
4: Leiterplatte
5: Lager
6: Niet
7: Erster Leiterbahnabschnitt
8: Zweiter Leiterbahnabschnitt (Abgriffsbahn)
9: Gleitbahn
10: Abnehmer
11: Markierung
12: Erhebung
13: Gehäuseöffnung
14: Erster Anschlusspunkt
15: Zweiter Anschlusspunkt
16: Verstellmittelrand
17: Verstellmittelkante
18: Sensor (kapazitiv/induktiv)
19: Metallisierter Abschnitt
20: Rastelement
21: Aufnahmeelement
22: Anschlagelement
23: Gegenanschlagelement
24: Leuchtmittel

Das erfindungsgemäße elektrische Klemmenmodul ist nachfolgend in bevorzugten Ausführungsbeispielen beschrieben und zeichnerisch dargestellt. In der Zeichnung zeigen
- Fig. 1:: Ein elektrisches Klemmenmodul in perspektivischer Ansicht
- Fig. 2:: Ein als Potentiometer aufgebautes verstellbares elektrisches Bauteil in noch nicht auf die Leiterplatte angeordneten Zustand mit einem am Verstellmittel angebauten Abnehmer
- Fig. 3:: Ein als Potentiometer aufgebautes verstellbares elektrisches Bauteil in noch nicht auf die Leiterplatte angeordneten Zustand mit Darstellung der Position des Abnehmers auf der Leiterplatte im eingebauten Zustand
- Fig. 4:: Eine Leiterplatte mit einem auf der Leiterplatte aufgebrachten verstellbaren elektronischen Bauteils innerhalb des teilweise aufgebrochen dargestellten Gehäuses des elektrischen Klemmenmoduls
- Fig. 5:: Ein als Schalter aufgebautes verstellbares elektrisches Bauteil innerhalb des elektrischen Klemmenmoduls im noch nicht auf die Leiterplatte angeordneten Zustand
- Fig. 6:: Einstellbares elektronisches Bauteil mit induktiver und/oder kapazitiver Ermittlung der Position des Verstellmittels
- Fig. 7:: Ein als veränderlicher Kondensator aufgebautes verstellbares elektrisches Bauteil in noch nicht auf die Leiterplatte angeordneten Zustand
- Fig. 8:: Ein als veränderlicher Kondensator aufgebautes verstellbares elektrisches Bauteil im auf die Leiterplatte im Gehäuse des elektrischen Klemmenmoduls montierten Zustand
- Fig. 9:: Eine Darstellung der Verrastungsmittel und Endanschläge des verstellbaren elektrischen Bauteils

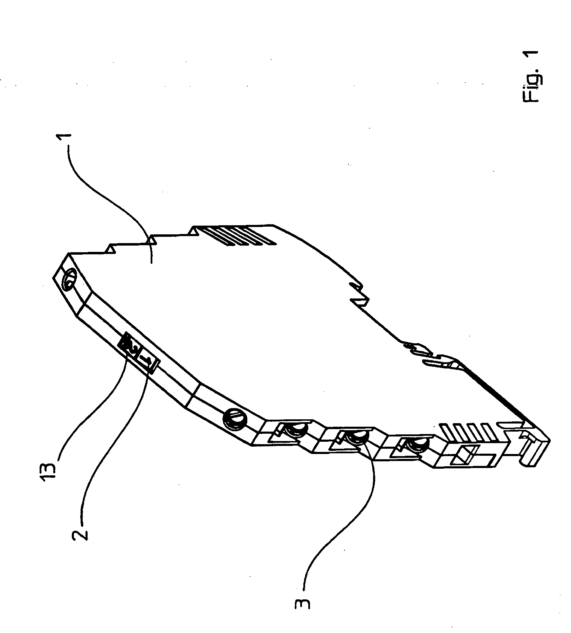

Fig. 1 zeigt ein bevorzugtes Ausführungsbeispiel eines elektrischen Klemmenmoduls der erfindungsgemäßen Art. Das Gehäuse weist zahlreiche Kontaktelemente 3 auf, an die elektrische Leitungen angeschlossen werden können. Die elektrischen Leitungen stellen Verbindungen zu Sensoren, Aktoren und/oder weiteren elektrischen Klemmenmodulen her. Die Befestigung der Leitungen an dem elektrischen Klemmenmodul erfolgt in bekannter Technik mittels Schraubklemmen, Federkraftklemmen oder dergleichen.

An der oberen Gehäuseseite ist das Verstellmittel 2 angeordnet, mit dem die Funktion des elektrischen Klemmenmoduls eingestellt oder verändert werden kann. Dazu ist in dem Gehäuse 1 eine Gehäuseöffnung 13 vorgesehen, durch die das Verstellmittel 2 verstellt werden kann. Das Verstellmittel 2 ist in Fig. 1 als Einstellrad ausgeführt und direkt auf der Leiterplatte 4 angeordnet.

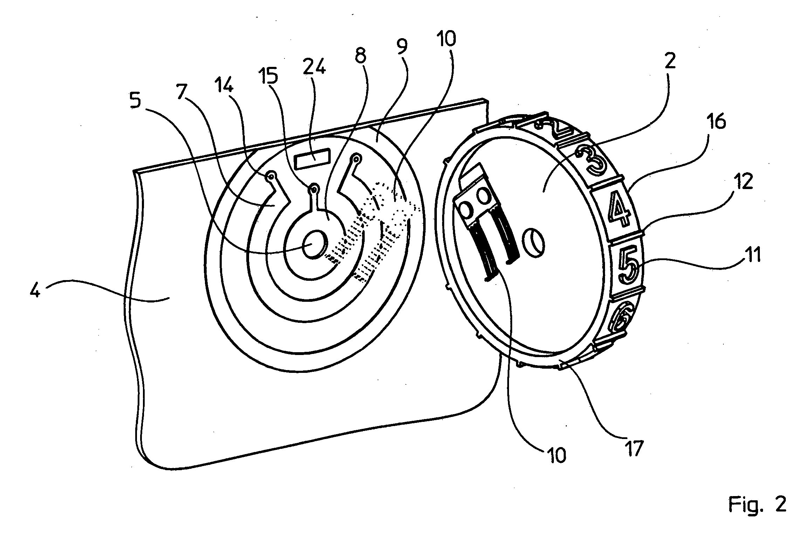

Fig. 2 zeigt das Verstellmittel im noch nicht auf die Leiterplatte angeordneten Zustand. Auf der Leiterplatte 4 ist zumindest ein erster Leiterbahnabschnitt 7 in Form einer Widerstandsgleitbahn und ein zweiter Leiterbahnabschnitt in Form einer Abgriffsbahn 8 vorgesehen, die über einen Abnehmer 10 elektrisch miteinander verbunden werden. Der Abnehmer 10 ist auf der der Leiterplattenoberfläche gegenüberstehenden Fläche des Verstellmittels 10 angeordnet. Der in Form einer Widerstandsgleitbahn vorgesehene Leiterbahnabschnitt 7 kann durch Auftragen einer widerstandsbehafteten Schicht, die Abgriffsbahn beispielsweise durch Auftragen einer elektrisch leitfähigen Schichtdirekt auf der Oberfläche der Leiterplatte 4 angeordnet werden.

Für die Befestigung des Abnehmers 10 auf und/oder an dem Verstellmittel 2 stehen verschiedene Möglichkeiten zur Verfügung. Geeignet sind beispielsweise die Befestigung mit Hilfe eines thermischen Verfahrens, bei dem der Abnehmer 10 nach einem Schmelzvorgang vom Kunststoff selbst gehalten wird. Alternativ kann der Abnehmer auch durch Klebetechniken oder durch eine Verrastung mit dem Verstellmittel 10 verbunden werden. Grundsätzlich sind alle Befestigungsmethoden geeignet, die eine Befestigung des Abnehmers 10 an der Oberfläche des Verstellmittels 2 ermöglichen, ohne dass dadurch die Bauhöhe des verstellbaren elektrischen Bauteils wesentlich erhöht wird.

Das Aufbringen sowohl der Widerstandsgleitbahn 7 als auch der Abgriffsbahn 8 kann in bekannter Weise durch Auftragen einer widerstandbehafteten und/oder elektrisch leitfähigen Schicht auf der Leiterplattenoberfläche erfolgen.

Durch Befestigung des Verstellmittels 2 durch ein Lager 5 auf der Leiterplatte 4 wird ein verstellbares elektrisches Bauteil gebildet, bei dem sich in der Schaltungsanordnung auf der Leiterplatte 4 eine elektrische Kenngröße wie ein Widerstand, eine Kapazität und/oder eine Induktivität einstellt. Mit dieser verstellbaren elektrischen Kenngröße können elektrische und/oder physikalische Eigenschaften einer Funktion des elektrischen Klemmenmoduls eingestellt werden.

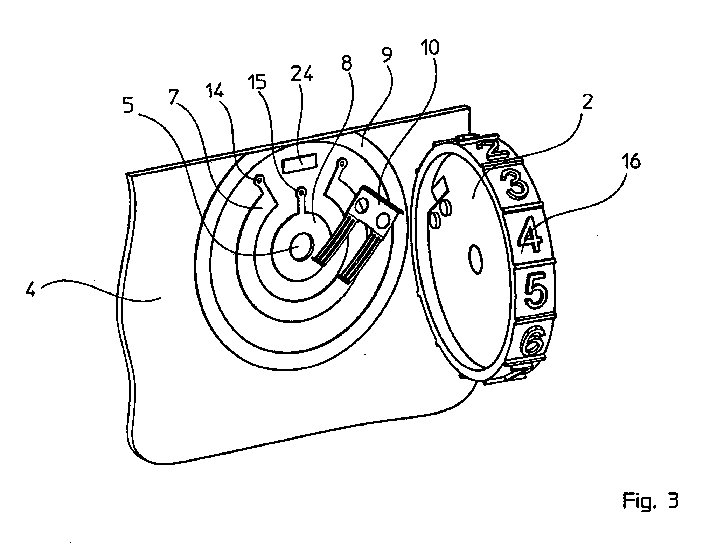

In Fig. 2 zeigt der gestrichelt dargestellte Abnehmer die Position des Abnehmers 10 wenn das Verstellmittel auf die Leiterplatte 4 angeordnet ist. Der Abnehmer 10 befindet sich mit einem seiner Schenkel auf der Widerstandsgleitbahn 7 und mit dem anderen Schenkel auf der Abgriffsbahn 8. Die Widerstandsgleitbahn 7 ist an zumindest einem ihrer Enden durch einen ersten Anschlusspunkt 14, die Abgriffsbahn 8 über einen zweiten Anschlusspunkt 15 mit weiteren in Fig. 2 nicht gezeigten elektrischen Bauteilen einer Schaltungsanordnung verbunden. Durch Anlegen einer Spannung an das elektrische Klemmenmodul fließt durch die Schaltungsanordnung ein Strom der über den ersten Anschlusspunkt 14 über einen Teil der Widerstandsgleitbahn 7 zu einem Schenkel des Abnehmers 10, weiter über den Abnehmer 10 zur Abgriffsbahn 8 und schließlich zum zweiten Anschlusspunkt 15 in die Schaltungsanordnung zurück fließt, wodurch sich als elektrische Kenngröße zwischen dem ersten und zweiten Anschlusspunkt 14, 15 ein elektrischer Widerstand des verstellbaren elektrischen Bauteils einstellt. Der elektrische Widerstand lässt sich durch Drehen des Verstellmittels 2 verändern. Wird der Abnehmer 10 so verstellt, dass der Strom vom ersten Anschlusspunkt 14 kommend einen längeren Abschnitt der Widerstandsgleitbahn 7 durchfließen muss, ist der resultierende Widerstand des verstellbaren elektrischen Bauteils größer, ist der Abschnitt dagegen kleiner, nimmt der resultierende Widerstandswert ab. Damit stellt das in Fig. 2 und 3 gezeigte verstellbare elektrische Bauteil die Funktion eines Potentiometers zur Verfügung, das über die Anschlusspunkte 14 und 15 mit weiteren Bauteilen in der Schaltungsanordnung auf der Leiterplatte 4 verbunden ist.

Mit der elektrischen Kenngröße des verstellbaren elektrischen Bauteils lassen sich die physikalischen Eigenschaften einer von dem elektrischen Klemmenmodul ausgeführten Funktion, wie beispielsweise Verzögerungszeiten und dergleichen einstellen.

In Fig. 3 ist zur Verdeutlichung die Positionierung des Abnehmers 10 auf der Widerstandsgleitbahn 7 und der Abgriffsbahn 8 gezeigt, wenn im zusammengebauten Zustand das Verstellmittel 2 mit aufgebrachtem Abnehmer 10 auf der Leiterplatte 4 angeordnet ist.

Dadurch, dass der Abnehmer 10 innerhalb des Verstellmittels 2 angeordnet und die Widerstandsbahn 7 und die Abgriffsbahn 8 direkt auf der Leiterplattenoberfläche aufgebracht sind, ist ein kompaktes verstellbares elektrisches Bauteil gebildet worden. Die Bauhöhe des verstellbaren elektrischen Bauteils wird hauptsächlich durch die Breite seines Verstellmittelrands 16 bestimmt. Der Verstellmittelrand 16 ist deutlich größer, als der Rand der aus dem Stand der Technik bekannten Verstellmittel, da der Verstellmittelrand 16 den gesamten Raum zwischen der Oberfläche der Leiterplatte 4 und der ihr gegenüberliegenden Gehäusewand nutzen kann. Er wird dadurch breiter, lässt sich besser bedrucken, ist leichter ablesbar und kann einfacher verstellt werden.

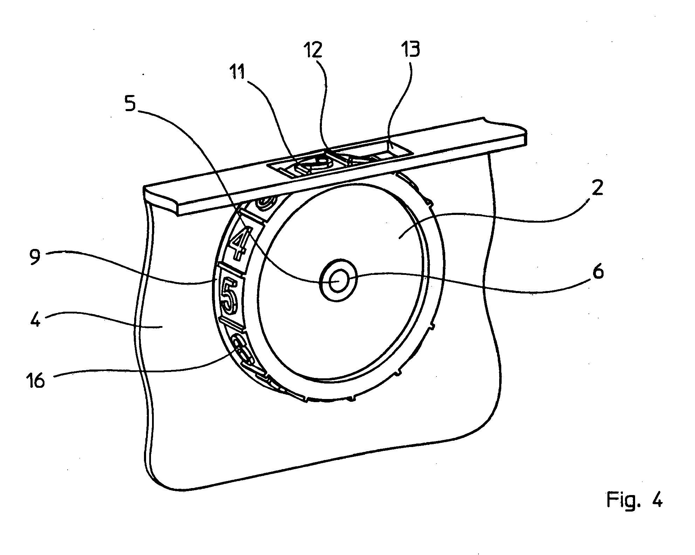

Die Lagerung des Verstellmittels 2 erfolgt unmittelbar auf der Leiterplatte 4 in dem Lager 5. Zur Verstellung des verstellbaren elektrischen Bauteils wird auf den Verstellmittelrand 16 eine Kraft ausgeübt, die zu einer Drehung des Verstellmittels 16 führt. Das Lager 5 des Verstellmittels 2 leitet die auftretenden Kräfte an die Leiterplatte 4 ab. In Fig. 4 wird für die Befestigung des Verstellmittels 2 auf der Leiterplatte 4 ein Niet 6 verwendet. Durch das Vernieten des Verstellmittels 2 sind keine weiteren Halte- oder Lagerteile notwendig, so dass die Bauhöhe des verstellbaren elektrischen Bauteils im Wesentlichen nur von der Breite des Verstellmittelrandes 16 und der Leiterplattendicke bestimmt wird. Alternativ kann anstelle eines Niets 6 jede weitere Befestigungsart verwendet werden, die eine Verstellbarkeit des Verstellmittels 2 erlaubt, solange die Gesamthöhe des verstellbaren elektrischen Bauteils durch das Befestigungsmittel nicht wesentlich vergrößert wird. So ist grundsätzlich auch ein Verrasten des Verstellmittels 2 auf der Leiterplatte 4 möglich.

Über den Niet 6 ist zusätzlich die Herstellung einer elektrisch leitenden Verbindung zwischen dem Verstellmittel 2 und der Leiterplatte 4 mit der elektrischen Schaltungsanordnung möglich. Er kann daher auch mit dem zweiten Anschlusspunkt 15 des verstellbaren elektrischen Bauteils verbunden sein.

Die unmittelbare Lagerung des Verstellmittels 2 im Lager 5 auf der Leiterplatte 4 leitet die bei der Verstellung des Verstellmittels auftretenden Kräfte, direkt an die Leiterplatte 4 ab. Für den Einbau in ein elektrisches Klemmenmodul in "Schmalbauweise" mit einer Baubreite unter acht Millimeter sollte der Spalt zwischen der Verstellmittelkante 17 und der Leiterplatte 4 minimal sein, um das Verstellmittel 2 möglichst dicht an der Leiterplatte 4 positionieren und damit weiteren Platz einsparen zu können. Auch die Stabilität des Verstellmittels 2 und des verstellbaren elektrischen Bauteils lasst sich dadurch weiter erhöhen.

Durch die direkte Anordnung des Verstellmittels 2 auf der Leiterplatte 4 besteht die Gefahr, dass die Verstellmittelkante 17 auf der Leiterplatte reibt und das Material der Leiterplatte 4 mit einer zunehmenden Anzahl von Verstellungen beschädigt. Um das zu verhindern, kann auf der Leiterplatte 4 eine Gleitbahn 9 vorgesehen werden, auf der die Kante des Verstellmittels 17 gleitend gelagert wird. Die Gleitbahn 9 kann durch Aufbringen einer weiteren elektrisch leitfähigen und/oder einer widerstandsbehafteten Schicht auf der Leiterplatte 4 gebildet werden, wobei ihre Geometrie im Wesentlichen mit der Geometrie der Verstellmittelkante 17 übereinstimmen sollte, jedoch nicht über den kompletten Umfang des Verstellmittels vorhanden sein muss. Es reicht aus, wenn die Gleitbahn 9 zum Abstützen des Verstellmittels 2 wenigstens zwei Abschnitte auf der Leiterplatte 4 aufweist. Diese Abschnitte können z. B. auch als Vorwiderstände und/oder als zusätzliche Widerstände innerhalb der Schaltungsanordnung oder als Vorwiderstände für die einstellbare elektrische Kenngröße verwendet werden.

Um eine Abnutzung der Gleitbahn 9 zu verhindern, kann das elektrisch leitfähige Material der Gleitbahn 9 einen höheren Glasanteil aufweisen. Durch die zusätzliche Gleitbahn 9 wird sowohl die Lagerung des Verstellmittels 2 im Lager 5 auf der Leiterplatte 4 verstärkt, als auch die Möglichkeit eines noch kompakteren und stabileren Aufbaus des verstellbaren elektrischen Bauteils ermöglicht.

Wie in den Figuren gezeigt, sind auf dem äußeren Umfang des Verstellmittels 2 Markierungen 11 vorgesehen, die eine Einstellung der elektrischen Kenngröße in vordefinierten Schritten ermöglichen.

Zwischen den Markierungen sind Erhebung 12 angeordnet, die die einzelnen Markierungen voneinander trennen. Die Erhebungen 12 können auch als Aussparungen im Material des Verstellmittels 2 ausgeführt sein. Die in den Figuren gezeigten Markierungen 11 sind beispielhaft als Zahlensymbole ausgeführt. Alternativ können aber auch Buchstaben, Punkte, Striche oder dergleichen oder auch in Kombination verwendet werden. Die Zahlensymbole können z. B. vordefinierte Einstellstufen wie beispielsweise Betriebsarten oder Wertebereich und/oder reale physikalische Werte wie z. B. fünf Milliampere, fünf Sekunden, fünf Prozent vom Bereichsendwert oder dergleichen symbolisieren. Soll beispielsweise ein Strom von fünf Milliampere oder eine Abschaltzeit von fünf Sekunden eingestellt werden, so muss das Verstellmittel 2 lediglich so weit gedreht werden, bis die Zahl Fünf innerhalb der Öffnung des Gehäuses 13 erscheint. Die Markierungen 11 können also so auf dem Verstellmittelrand 16 angeordnet werden, dass sie dem Wert der einzustellenden elektrischen und/oder physikalischen Funktion des elektrischen Klemmenmoduls oder auch einen prozentualen Anteil eines Bereichsendwerts oder dergleichen entsprechen. Stellt das elektrische Klemmenmodul beispielsweise eine Zeitfunktion zur Verfügung, bei der ein Schaltvorgang mit einer Verzögerung von fünf Millisekunden ausgelöst werden soll, so verstellt ein Bediener das Verstellmittel soweit, bis die Markierung Fünf innerhalb der Gehäuseöffnung 13 erscheint.

Die Markierungen 11 können auch eine prozentuale Angabe in Bezug auf einen Nennbereich symbolisieren. So kann beispielsweise die Einstellung der Markierung Fünf anzeigen, dass der aktuell eingestellte Wert fünfzig Prozent von einem festgelegten Bereichsendwert entspricht. Reicht der einzustellende Wertebereich einer Funktion des elektrischen Klemmenmoduls von Null bis zwanzig Milliampere oder von Null bis dreihundert Sekunden, würde bei Positionierung der Markierung 5 in die Öffnung 13 des Gehäuses 1 ein Wert von zehn Milliampere bzw. einhundertfünfzig Sekunden entsprechen. Selbstverständlich kann dieser Zusammenhang auch durch einen Strich mit halber Länge dargestellt werden, wenn der Bereichsendwert durch einen Strich mit in etwa der Länge der Breite des Randes 16 des Verstellmittels 2 und der Bereichsanfangswert ohne einen Strich oder nur als Punkt symbolisiert wird.

Das innerhalb der Schaltungsanordnung angeordnete verstellbare elektrische Bauteil muss dann so dimensioniert werden, dass ein Schaltvorgang nach der gewünschten Zeit, dem Beispiel folgend also nach fünf Millisekunden, ausgelöst wird. Der bei der Stellung Fünf eingestellte Widerstandswert des Potentiometers wirkt mit der Schaltungsanordnung auf der Leiterplatte 4 dann so zusammen, dass ein Zeitglied mit einer Verzögerungszeit von fünf Sekunden gebildet wird. Selbstverständlich lassen sich mit dem verstellbaren elektrischen Bauteil und der auf der Leiterplatte 4 aufgebrachten Schaltungsanordnung mit mehreren elektrischen und/oder elektronischen Bauelementen weitere physikalische Größen und/oder Parameter der durch das elektrische Klemmenmodul zur Verfügung gestellten Funktion einstellen.

Über die Anzahl der Markierungen 11 auf dem Verstellmittelrand 16 und deren Abstände zueinander kann die Genauigkeit der Einstellung festgelegt werden. Ferner ist die Genauigkeit der Einstellung auch von dem Radius des Verstellmittels 2 abhängig. Je mehr Markierungen 11 und/oder Aussparungen bzw. Erhebungen 12 vorgesehen sind und/oder je größer der Radius des Verstellmittels 2 ist, desto genauer und/oder feiner kann die Einstellung der elektrischen Kenngröße des verstellbaren elektrischen Bauteils vorgenommen werden. Die Einstellgenauigkeit der aus dem Stand der Technik bekannten gattungsgemäßen elektrischen Klemmenmodule von typischerweise fünf Prozent kann so auf einen Wert kleiner oder gleich 2,5 Prozent vom Bereichsendwert erhöht werden.

Fig. 4 zeigt die Anordnung des Verstellmittels 2 auf der Leiterplatte 4, wenn das Verstellmittel 2 durch Vernieten auf der Leiterplatte angeordnet ist. Ein Teil des Randes 16 des Verstellmittels 2 kann aus der Gehäuseöffnung 13 des elektrischen Klemmenmoduls hinaus ragen oder auch darunter angeordnet sein. Ragt der Rand 16 des Verstellmittels nicht aus der Öffnung 13 des Gehäuses des elektrischen Klemmenmoduls hinaus, kann beispielsweise ein transparentes Siegel zur Absicherung gegen unbeabsichtigte Verstellungen und/oder schädlichen Umwelteinflüssen angeordnet werden. Hierdurch wird eine Versiegelung der Öffnung 13 erreicht bzw. das Gehäuse 1 so abgeschlossen, dass Umwelteinflüsse vom Inneren des elektrischen Klemmenmoduls abgeschirmt werden. Die Verstellung des Verstellmittels 2 erfolgt durch Drehen des Verstellmittels 2 an seinem Rand 16. Die gezeigte Erhebung 13, die alternativ auch als eine kerbenförmige Aussparung realisiert werden kann, erlaubt eine leichtere und genauere Verstellung des Verstellmittels 2. Aufgrund der geringen Breite des Verstellmittelrandes kann zur besseren Verstellbarkeit auch ein schmaler Schraubendreher verwendet werden, dessen Spitze an der Erhebung 12 oder in einer entsprechenden kerbenförmigen Aussparung eingreifen kann.

Die geringe Breite des Verstellmittelrandes 16 oder ein Einbau des elektrischen Klemmenmoduls an einem unzureichend beleuchteten Einbauort kann das Ablesen der Markierungen erschweren. Für diesen Fall kann das Verstellmittel 2 aus einem transparenten und/oder lichtdurchlässigen Material hergestellt sein. Bevorzugt ist zur besseren Ablesbarkeit eine Anordnung des Leuchtmittels 24 auf der Leiterplatte 4 unterhalb des Verstellmittels 2 in der Nähe der Gehäuseöffnung 13 vorgesehen. Das Leuchtmittel 24 kann aber auch auf der der Gehäuseöffnung 13 gegenüberliegenden Seite des Verstellmittels 2 oder seitlich von ihm angeordnet werden.

Über die Beleuchtung des Verstellmittels 2 hinaus, können mit dem Leuchtmittel 24 auch Diagnoseinformationen über den Zustand des elektrischen Klemmenmoduls oder auch Bereichsüberschreitungen, eine Visualisierung von Schaltvorgängen, positive oder negative Ergebnisse eines ausgeführten Selbsttests und dergleichen signalisiert werden. So können beispielsweise Fehler in dem elektrischen Klemmenmodul durch unterschiedliche Blinkfrequenzen, Intensitäten und/oder Farben zur Anzeige gebracht werden. Im einfachsten Fall wird mit dem Leuchtmittel 24 eine angelegte Betriebsspannung und/oder die Betriebsbereitschaft des elektrischen Klemmenmoduls angezeigt.

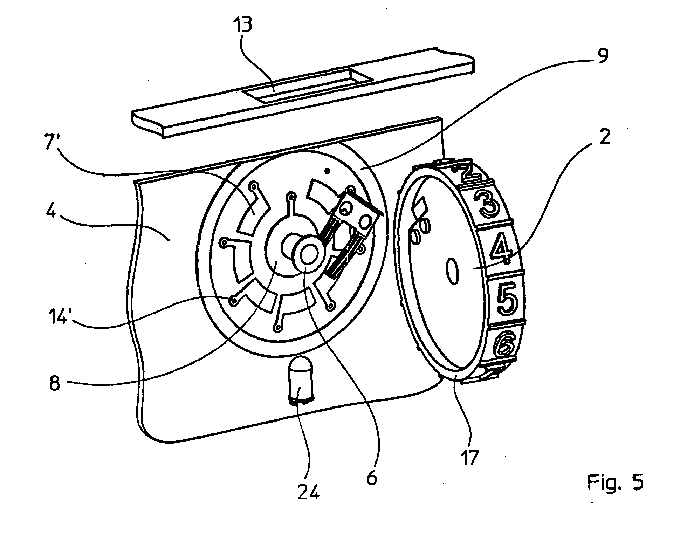

Fig. 5 zeigt die Realisierung einer Schaltfunktion mit Hilfe des Verstellmittels 2, des Abnehmers 10, einen durch nicht leitfähige Abschnitte unterbrochenen ersten Leiterbahnabschnitt 7' und einen zweiten Leiterbahnabschnitt in Form einer Abgriffsbahn 8. Ein Schenkel des Abnehmers 10 ist im eingebauten Zustand mit der Abgriffsbahn 8 verbunden, während der andere Schenkel beim Verdrehen des Verstellmittels 2 abwechselnd über leitfähige und nicht leitfähige Abschnitte des ersten Leiterbahnabschnitts 7' streicht. Die leitfähigen Abschnitte des ersten Leiterbahnabschnitts 7' sind mit ersten Anschlusspunkten 14', die Abgriffsbahn 8 über einen zweiten Anschlusspunkt 15 mit den auf der Leiterplatte 4 angeordneten Bauteilen der Schaltungsanordnung verbunden.

Für den ersten Leiterbahnabschnitt 7' kann eine elektrisch leitfähige Leiterbahn und/oder eine widerstandsbehaftete Schicht verwendet werden.

Ein elektrischer Strom kann nur dann fließen, wenn sich beide Schenkel des Abnehmers über leitfähigem Material befinden. Der Strom fließt dann von der Schaltungsanordnung über einen ersten Anschlusspunkt 14', über den zumindest einen leitfähigen Abschnitt des ersten Leiterbahnabschnitts 7', weiter über den Abnehmer 10 zur Abgriffsbahn 8 und zur Schaltungsanordnung über den zweiten Anschlusspunkt 15. Durch diese Ausführungsform des verstellbaren elektrischen Bauteils kann eine Schaltfunktion z. B. zur Auswahl einer vordefinierten Betriebsart des elektrischen Klemmenmoduls ausgewählt werden. Die Anzahl der von dem verstellbaren elektrischen Bauteil zur Verfügung gestellten Schaltstellungen ist von der Anzahl der leitfähigen Abschnitte des ersten Leiterbahnabschnitts 7' abhängig. Die Schaltstellungen lassen sich beispielsweise auch für Kodierungen und/oder zu Adresseinstellungen verwenden, insbesondere wenn das elektrische Klemmenmodul als Teilnehmer eines Bussystems oder eines drahtlosen Netzwerkes ausgebildet ist. Mit einem Rad mit zehn Schaltstellungen könnte damit eine Adresse von Null bis Neun eingestellt werden können.

Im einfachsten Fall stellt das verstellbare elektrische Bauteil lediglich zwei Schalterstellungen zur Verfügung, mit denen das elektrische Klemmenmodul ein- und/oder ausgeschaltet werden kann.

Es ist weiter vorgesehen, sowohl die Schaltfunktion als auch die Potentiometerfunktion des verstellbaren elektrischen Bauteils durch eine entsprechende Anordnung von Leiterbahnabschnitten sowohl auf der Gleitbahn 9 als auch auf der Verstellmittelkante 17 des Verstellmittels 2 auszuführen, wodurch mit einem einzigen Bauteil gleich zwei verstellbare elektrische Bauteile gebildet werden können. Bei der Ausführungsform als verstellbarer elektrischer Widerstand kann der Strom beispielsweise von einem auf der Verstellmittelkante 17 angeordneten Abgriff aufgenommen und über den Niet 6 an die Schaltungsordnung auf der Leiterplatte 4 weiter geleitet werden.

Im einfachsten Fall kann die durch ein widerstandbehaftetes Material gebildete Gleitbahn 9 als zusätzlicher Widerstand verwendet werden. Mehrere Widerstände können gebildet werden, wenn die Gleitbahn zumindest in zwei Abschnitte unterteilt ist.

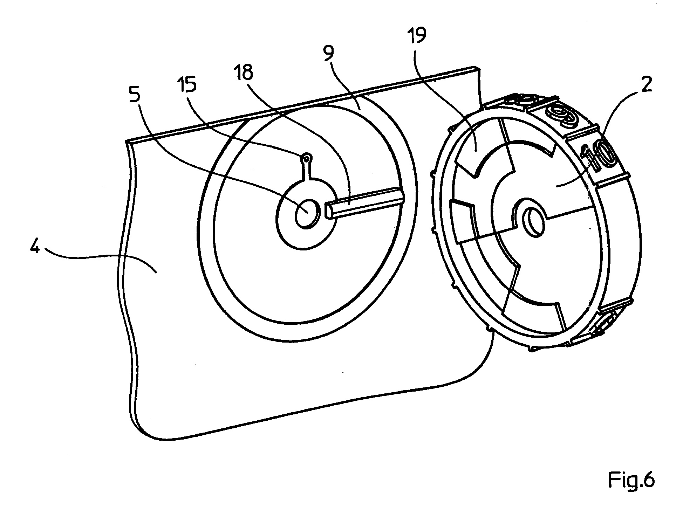

Fig. 6 zeigt eine Ausführungsform des verstellbaren elektrischen Bauteils bei dem die Stellung des Verstellmittels 2 über einen induktiven oder kapazitiven Sensor 18 ermittelt wird. Dazu ist auf der Leiterplatte 4 unterhalb des Verstellmittels 2 ein induktiver und/oder kapazitiver Sensor 18 angeordnet. Auf der der Leiterplatte 4 zugewandten Fläche des Verstellmittels 2 sind mehrere metallisierte Abschnitte 19 angeordnet. Der Sensor bzw. eine mit dem Sensor verbundene Auswerteschaltung (nicht gezeigt) wertet die absolute und/oder relative Position des Verstellmittels 2 über der Leiterplatte 4 aus. Bei Drehung des Verstellmittels 2 überstreichen die metallisierten Abschnitte 19 auf dem Verstellmittel 2 den Sensor 18, wobei von dem Sensor 18 jeweils ein Impuls generiert wird. Die Anzahl der Impulse ist proportional zu dem bei der Drehung zurückgelegten Weges des Verstellmittels 2. Über eine entsprechende, aus dem Stand der Technik an sich bekannte Anordnung der metallisierten Flächen lässt sich auch die Drehrichtung des Verstellmittels 2 ermitteln. Der Sensor selbst und/oder die mit ihm verbundene Auswerteschaltung erzeugt eine elektrische Kenngröße, die dem Verstellweg proportional ist und mit der die Funktion des elektrischen Klemmenmoduls eingestellt bzw. verändert werden kann. Über die Ermittlung der Drehrichtung ist feststellbar, ob der Wert der eingestellten elektrischen Kenngröße verringert oder erhöht werden soll.

Selbstverständlich ist mit Ersatz eines kapazitiven und/oder induktiven Sensors 18 unterhalb des Verstellmittels 2 durch einen optischen Sensor und dem Aufbringen eines an sich bekannten Hell/Dunkel-Musters, vorzugsweise ein geeignetes, ebenfalls bekanntes Strichmuster, auf der der Leiterplatte 4 gegenüberliegenden Fläche des Verstellmittels 2 auch eine optische Erfassung der Stellung des Verstellmittels 2 und/oder eine Ermittlung der Drehrichtung möglich.

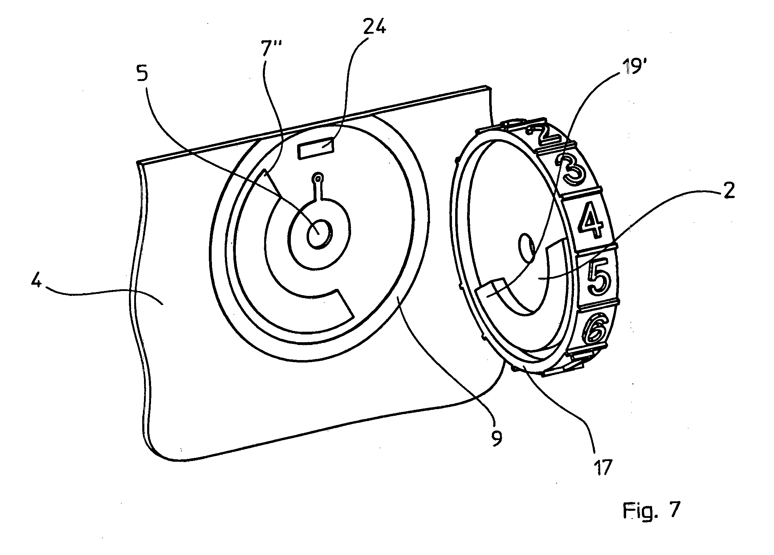

Fig. 7 zeigt ein Ausführungsbeispiel des verstellbaren elektrischen Bauteils innerhalb des elektrischen Klemmenmoduls als verstellbaren Kondensator. Hierzu ist auf der Leiterplatte 4 unterhalb des Verstellmittels 2 jeweils ein erster Leiterbahnabschnitt 7" in Form einer metallisierten Fläche und auf der der Leiterplatte gegenüberliegenden Fläche des Verstellmittels 2 ein metallisierter Abschnitt 19' angeordnet. Beide Flächen stehen sich so gegenüber, dass sie mit Drehung des Verstellmittels 2 zumindest teilweise in Überlappung gebracht werden können. Je mehr metallisierte Fläche sich gegenüber steht, desto größer ist die resultierende Kapazität des verstellbaren elektrischen Bauteils. Die beiden Leiterbahnabschnitte (7", 19') sind jeweils mit ersten und zweiten Anschlusspunkten auf der Leiterplatte 4 verbunden (nicht gezeigt). Der zweite Anschlusspunkt des metallisierten Leiterbahnabschnitts 19' auf dem Verstellmittel 2 kann beispielsweise mit dem Niet 6 über das Lager 5 mit der Leiterplatte verbunden sein. Über die Form des Leiterbahnabschnitts 7" und die Form des metallisierten Abschnitts 19' z. B. mit einer über die Länge zunehmenden Breite können auf einfache Art auch nicht lineare Einstellungen vorgenommen werden.

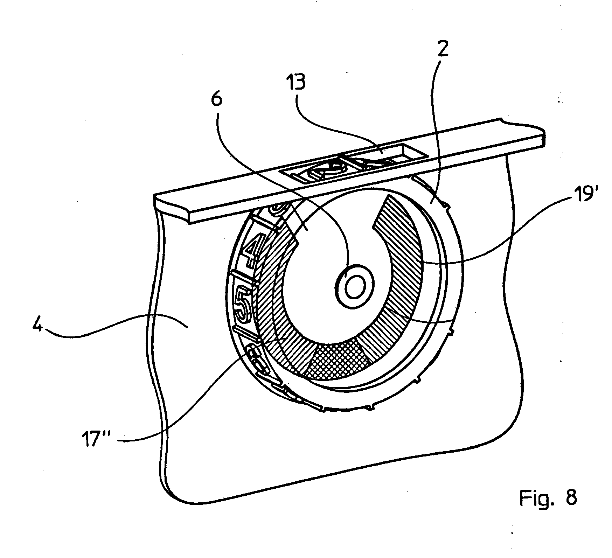

Fig. 8 zeigt das verstellbare elektrische Bauteil im zusammen gebauten Zustand innerhalb des elektrischen Klemmenmoduls. Die beiden sich zumindest teilweise gegenüber liegenden metallisierten Leiterbahnabschnitte (7", 19') sind schraffiert dargestellt.

Da die Kapazität des verstellbaren Kondensators u. a. von der Breite des Luftspalts zwischen dem metallisierten Leiterbahnabschnitt 19' und dem ersten Leiterbahnabschnitt 7" auf der Leiterplatte 4 abhängt, kann es notwendig sein, den Luftspalt zu gering wie möglich zu dimensionieren, um eine höhere Kapazität zu erreichen. Dazu kann das Verstellmittel 2 so ausgebildet sein, dass der auf ihm angeordnete metallisierte Leiterbahnabschnitts 19' näher an die Oberfläche der Leiterplatte 4 positioniert wird. Dazu ist lediglich die der Leiterplatte 4 gegenüberstehende Flächen des Verstellmittels 2 näher an seine Kante 17 anzuordnen.

Zusätzlich kann zur Erhöhung der Kapazität des verstellbaren elektrischen Bauteils in dem Luftspalt zwischen dem Leiterbahnabschnitt 7" und dem metallisierten Leiterbahnabschnitt 19' eine zusätzliche dielektrische Schicht beispielsweise in Form einer Folie, angeordnet werden, die mit dem Niet 6 zwischen dem Verstellmittel 2 und der Leiterplatte 4 befestigt wird. Befindet sich der Leiterbahnabschnitt 7" in einer Schicht der Leiterplatte selbst, kann die dielektrische Schicht auch durch das Material der Leiterplatte selbst gebildet sein. Beide Möglichkeiten der Kapazitätserhöhung können auch in Kombination wirken.

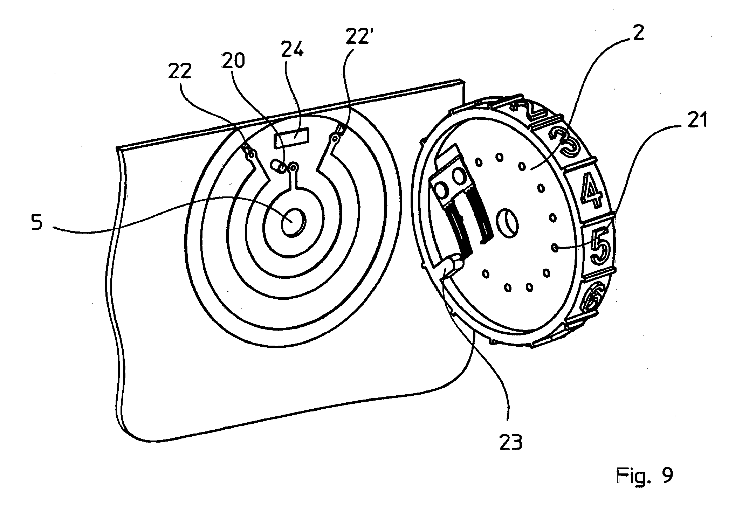

Fig. 9 zeigt das verstellbare elektrische Bauelement in Form eines Potentiometers. Auf der der Einstellvorrichtung 2 gegenüberliegenden Oberfläche der Leiterplatte 4 ist ein Rastelement 20 vorgesehen, das mit einer Seite mit der Leiterplatte 4 fest verbunden ist. Auf der anderen Seite ist ein kugelförmiger, vorzugsweise federnd gelagerter Kopf vorgesehen. Auf der der Leiterfläche gegenüberliegenden Fläche der Einstellvorrichtung 2 sind in regelmäßigen Abständen Aufnahmeelemente 21 auf einer Kreisbahn angeordnet. Der Radius der Kreisbahn, vom Mittelpunkt des Einstellelements 2 gemessen, ist so groß, wie der Abstand zwischen dem Rastelements 20 von dem Lager 5. Die Aufnahmelemente 21 und das Rastelement 20 bilden die Verrastungsmittel. Beim Drehen der Einstellvorrichtung 2 bewegt sich die Kugel des Rastelements auf der Kreisbahn und greift nach Erreichen eines der Aufnahmeelemente 21 in dieses ein. Hierdurch wird einem Bediener mitgeteilt, dass eine vorbestimmte Einstellposition der Einstellvorrichtung 2 erreicht worden ist.

Ferner können auf der Oberfläche der Leiterplatte 4 Anschlagelemente 22, 22' angeordnet sein, die mit Gegenanschlagelementen 23 auf der der Fläche der Leiterplatte 4 gegenüberliegenden Fläche des Verstellmittels 2 so zusammen wirken, dass bei der Verstellung des Verstellmittels 2 eine definierte Anfangs-und/oder Endstellung des verstellbaren elektrischen Bauteils festgelegt wird. Stößt das Gegenanschlagelement 23 gegen eines der Anschlagelemente 22, 22', ist die Anfangs- und/oder Endstellung erreicht. Ein Überdrehen des verstellbaren elektrischen Bauteils kann so wirkungsvoll verhindert werden. Sind keine Anfangs- und/oder Endstellungen vorgesehen, kann die elektrische Schaltungsanordnung auf der Leiterplatte überwachen, ob das Verstellmittel 2 vom Bediener in einen Bereich gedreht wurde, in dem die Elemente und Gegenelemente des verstellbaren elektronischen Bauteils nicht mehr wie vorgesehen zusammen wirken können. Ein solcher Fall könnte eintreten, wenn wie in Fig. 3 gezeigt, der Abnehmer zwischen den Anschlusspunkten 14, 15 gedreht worden ist. Eine solche Überschreitung des vorgesehen Verstellbereichs kann beispielsweise über das Leuchtmittel 24 in Form einer Fehlermeldung angezeigt werden.

Die der Leiterplattenoberfläche zugewandten Fläche des Verstellelements 2 kann selbst Leiterbahnen und/oder elektrische Bauteile aufnehmen, die beispielsweise mittels MID-Technik direkt auf dem Kunststoff aufgebracht werden können. Bei der MID-Technik handelt es sich um ein Verfahren, mit dem Leiterbahnen und/oder elektrische Bauteile ohne die Verwendung einer Leiterplatte direkt innerhalb des Kunststoffs des Verstellmittels 2 oder darauf angeordnet werden können. Die so aufgebrachten Leiterbahnen können mit dem Niet 6 und/oder den metallisierten Flächen auf der Kante 17 des Verstellelements 2 verbunden sein. Hierdurch ist eine noch flexiblere Verbindung zwischen den auf dem Verstellelement 2 angeordneten Gegenelementen 7, 8; 18 zu- und/oder untereinander und/oder zu den auf der Verstellmittelkante 17 aufgebrachten metallisierten Flächen erreichbar. Auch die metallisierten Flächen der Verstellmittelkante 17 können auf diese Weise zur weiteren Erhöhung der Flexibilität des verstellbaren elektrischen Bauteils miteinander verschaltet werden.

## Patentansprüche

1. Elektrisches Klemmenmodul mit einer Vielzahl von elektrischen Kontaktelementen (3) zum Anschluss elektrischer Leiter, einem Gehäuse (1) zur Aufnahme zumindest einer Leiterplatte (4), auf der eine Schaltungsanordnung mit mehreren elektrischen Bauelementen zur Ausführung einer vorbestimmten Funktion, insbesondere einer Zeitschaltfunktion, angeordnet ist und Verstellmitteln (2) zur Veränderung zumindest einer elektrischen Kenngröße der Schaltungsanordnung, wobei zumindest ein Teil des Verstellmittels (2) durch eine Öffnung (13) in zumindest einer Seitenwand des Gehäuses bedienbar und von außen verschwenkbar oder verdrehbar ist,
**dadurch gekennzeichnet, dass**
das Verstellmittel (2) durch ein Lager (5) unmittelbar auf der Leiterplatte (4) gelagert ist.

2. Elektrisches Klemmenmodul nach Anspruch 1,
**dadurch gekennzeichnet, dass**
die Lagerung des Verstellmittels (2) durch Vernieten und/oder Verrasten des Verstellmittels (2) im Lager (5) auf der Leiterplatte (4) und/oder durch ein auf einer Seite des Verstellmittels gegenüberliegenden Gehäuseinnenseite angeformtes Gehäuseteil erfolgt.

3. Elektrisches Klemmenmodul nach einem der Ansprüche 1 oder 2,
**dadurch gekennzeichnet, dass**
auf der Leiterplatte (4) Mittel zur Abstützung des Verstellmittels (2) auf der Leiterplatte (4) vorgesehen sind.

4. Elektrisches Klemmenmodul nach Anspruch 3,
**dadurch gekennzeichnet, dass**
die Mittel zur Abstützung des Verstellmittels (2) auf der Leiterplatte durch eine auf der Leiterplatte angeordnete Gleitbahn (9) gebildet werden, deren Geometrie zumindest teilweise mit der Geometrie des Verstellmittels (2) korrespondiert.

5. Elektrisches Klemmenmodul nach einem der Ansprüche 1 bis 4,
**dadurch gekennzeichnet, dass**
auf der der Leiterplattenoberfläche zugewandten Fläche des Verstellmittels (2) Elemente (10, 19) vorgesehen sind, die mit auf und/oder innerhalb der Leiterplatte (4) angeordneten Gegenelemente (7, 8; 18) so zusammen wirken, dass zwischen ihnen bei Zuführung einer Spannung eine elektrische Keringröße gebildet wird.

6. Elektrisches Klemmenmodul nach Anspruch 5,
**dadurch gekennzeichnet, dass**
die zwischen den Elementen des Verstellmittels (10, 19) und den Gegenelementen (7, 8; 18) auf und/oder in der Leiterplatte (4) gebildete Kenngröße ein elektrischer Widerstand, eine Kapazität und/oder eine Induktivität ist.

7. Elektrisches Klemmenmodul nach einem der Ansprüche 5 oder 6,
**dadurch gekennzeichnet dass**,
durch die Elemente des Verstellmittels (10, 19) und den Gegenelementen (7, 8; 18) auf und/oder in der Leiterplatte (4) unterschiedliche Strompfade einstellbar sind.

8. Elektrisches Klemmenmodul nach einem der vorherigen Ansprüche 5 bis 7,
**dadurch gekennzeichnet, dass**
durch die Elemente des Verstellmittels (10, 19) und den Gegenelementen (7, 8; 18) auf und/oder innerhalb der Leiterplatte (4) eine optische, kapazitive und/oder induktive Erfassung einer relativen und/oder absoluten Stellung des Verstellmittels (2) zur Leiterplatte (4) bewirkt wird.

9. Elektrisches Klemmenmodul nach einem der Ansprüche 1 bis 8,
**dadurch gekennzeichnet, dass**
zwischen der auf der Leiterplatte zugewandten Kante (17) des Verstellmittels und dazu gegenüber auf der Leiterplatte (4) weitere Elemente angeordnet sind, die so zusammen wirken, dass zwischen ihnen bei Zuführung einer Spannung eine zweite elektrische Kenngröße gebildet wird.

10. Elektrisches Klemmenmodul nach einem der vorherigen Ansprüche 1 bis 9,
**dadurch gekennzeichnet, dass**
auf und/oder innerhalb der Leiterplatte (4) Verrastungsmittel des Verstellmittels (2) in vorbestimmten Abständen angeordnet sind.

11. Elektrisches Klemmenmodul nach einem der vorherigen Ansprüche 1 bis 10,
**dadurch gekennzeichnet, dass**
das Verstellmittel (2) aus einem transparenten und/oder lichtdurchlässigen Material besteht und dass auf und/oder in der Leiterplatte (4) Mittel zur Beleuchtung (24) des Verstellmittels vorgesehen sind.

12. Elektrisches Klemmenmodul nach einem der vorherigen Ansprüche 1 bis 11,
**dadurch gekennzeichnet, dass**
das Verstellmittel (2) als Rad ausgebildet ist, auf dessen äußeren Umfang (16) Markierungen (11) vorgesehen sind, die eine Einstellung der elektrischen Kenngröße in vorgegebenen Schritten ermöglichen.

13. Elektrisches Klemmenmodul nach Anspruch 12, **dadurch**
**gekennzeichnet, dass**
zwischen den Markierungen (11) kerbenförmige Aussparungen und/oder Erhebungen (12) angeordnet sind.

14. Elektrisches Klemmenmodul nach einem der Ansprüche 12 oder 13,
**dadurch gekennzeichnet, dass**
die Markierungen (11) einen logischen Bezug zur der jeweils mittels des Verstellmittels (2) eingestellten elektrischen Kenngröße aufweisen.

15. Elektrisches Klemmenmodul nach einem der vorherigen Ansprüche 1 bis 14,
**dadurch gekennzeichnet, dass**
auf der Leiterplatte (4) Anschläge zur Festlegung einer Anfangs-und/oder Endstellung des Verstellmittels (2) angeordnet sind.

16. Elektrisches Klemmenmodul nach einem der vorherigen Ansprüche 1 bis 15,
**dadurch gekennzeichnet, dass**
das Verstellmittel (2) mit seiner Verstellmittelkante (17) sowohl die Elemente(10, 19) auf dem Verstellmittel (2) als auch die auf der Leiterplatte 4 angeordneten Gegenelemente (7, 8; 18) vollständig umfasst.

17. Elektrisches Klemmenmodul nach einem der vorherigen Ansprüche 1 bis 16,
**dadurch gekennzeichnet, dass**
die Baubreite des Gehäuses (1) höchsten 8 mm beträgt und/oder höchstens eineinhalb mal so groß ist wie die Höhe des Verstellmittels (2).

18. Elektrisches Klemmenmodul nach einem der vorherigen Ansprüche 1 bis 17,
**dadurch gekennzeichnet, dass**
auf der zum Verstellmittel (2) gegenüberliegenden Seite der Leiterplatte (4) ein zweites Verstellmittel (2') angeordnet ist,

19. Elektrisches Klemmenmodul nach Anspruch 18,
**dadurch gekennzeichnet, dass**
die Verstellmittel (2, 2') gemeinsam durch das Lager (5) auf den jeweils gegenüberliegenden Seiten der Leiterplatte (4) gelagert sind.

## Claims

1. Electrical terminal module with a plurality of electrical contact elements (3) for connecting electrical conductors, with a housing (1) for accommodating at least one printed circuit board (4), on which a circuit arrangement is arranged having a plurality of electrical components for executing a predetermined function, in particular a timing function, and with adjusting means (2) for modifying at least one electrical characteristic parameter of the circuit arrangement, wherein at least one part of the adjusting means (2) can be operated through an opening (13) in at least one side wall of the housing and can be pivoted or rotated from the outside,
**characterized in that**
the adjusting means (2) is mounted directly on the printed circuit board (4) by means of a bearing (5).

2. Electrical terminal module according to Claim 1,
**characterized in that**
the adjusting means (2) is mounted by riveting and/or locking of the adjusting means (2) in the bearing (5) on the printed circuit board (4) and/or by means of a housing part formed on one side of the inside housing opposite the adjusting means.

3. Electrical terminal module according to any one of Claims 1 or 2,
**characterized in that**
on the printed circuit board (4), means are provided for supporting the adjusting means (2) on the printed circuit board (4).

4. Electrical terminal module according to Claim 3,
**characterized in that**
the means for supporting the adjusting means (2) on the printed circuit board are formed by a sliding guide (9) arranged on the printed circuit board, the geometry of which at least partly corresponds to the geometry of the adjusting means (2).

5. Electric terminal module according to any one of Claims 1 to 4,
**characterized in that**
on the surface of the adjusting means (2) facing towards the surface of the circuit board, elements (10, 19) are provided that interact with mating elements (7,8; 18) arranged on and/or inside the circuit board (4), in such a manner that on application of a voltage an electrical characteristic parameter is formed between said elements.

6. Electrical terminal module according to Claim 5,
**characterized in that**
the electrical characteristic parameter formed between the elements of the adjusting means (10, 19) and the mating elements (7,8; 18) on and/or inside the printed circuit board (4) is an electrical resistance, a capacitance and/or an inductance.

7. Electrical terminal module according to any one of Claims 5 or 6,
**characterized in that**
different current paths can be adjusted by means of the elements of the adjusting means (10, 19) and the mating elements (7,8; 18) on and/or inside the printed circuit board (4).

8. Electrical terminal module according to any one of Claims 5 to 7,
**characterized in that**
an optical, capacitive and/or inductive detection of a relative and/or absolute position of the adjusting means (2) in relation to the circuit board (4) is effected by means of the elements of the adjusting means (10, 19) and the mating elements (7,8; 18) on and/or inside the printed circuit board (4).

9. Electrical terminal module according to any one of Claims 1 to 8,
**characterized in that**
additional elements are arranged on the printed circuit board (4) between the edge (17) of the adjusting means facing the printed circuit board and opposite thereto, which interact in such a manner that on the application of a voltage, a second electrical characteristic parameter is formed between them.

10. Electrical terminal module according to any one of Claims 1 to 9,
**characterized in that**
means of locking the adjusting means (2) are arranged at predetermined intervals on and/or inside the circuit board (4).

11. Electrical terminal module according to any one of Claims 1 to 10,
**characterized in that**
the adjusting means (2) consists of a transparent and/or translucent material, and that means of illuminating (24) the adjusting means are provided on and/or in the printed circuit board (4).

12. Electrical terminal module according to any one of Claims 1 to 11,
**characterized in that**
the adjusting means (2) is implemented in the form of a wheel, on the outer circumference (16) of which markings (11) are provided, which facilitate adjustment of the electrical characteristic parameter in predefined steps.

13. Electrical terminal module according to Claim 12,
**characterized in that**
notch-shaped recesses and/or elevations (12) are arranged between the markings (11).

14. Electrical terminal module according to any one of Claims 12 or 13,
**characterized in that**
the markings (11) are in a logical relation to the respective electrical characteristic parameter adjusted y means of the adjusting means (2).

15. Electrical terminal module according to any one of the preceding Claims 1 to 14,
**characterized in that**
arresters are arranged on the printed circuit board (4) for fixing a start position and/or end position of the adjusting means (2).

16. Electrical terminal module according to any one of the preceding Claims 1 to 15,
**characterized in that**
the adjusting means (2) with its adjusting means edge (17) completely encompasses both the elements (10, 19) on the adjusting means (2) and the mating elements (7,8; 18) arranged on the printed circuit board (4).

17. Electrical terminal module according to any one of the preceding Claims 1 to 16,
**characterized in that**
the assembled width of the housing (1) is a maximum of 8 mm and/or a maximum of one and a half times as large as the height of the adjusting means (2).

18. Electrical terminal module according to any one of the preceding Claims 1 to 17,
**characterized in that**
a second adjusting means (2') is arranged on the side of the printed circuit board (4) opposite the adjusting means (2).

19. Electrical terminal module according to Claim 18,
**characterized in that**
the adjusting means (2, 2') are mounted on the respective opposite sides of the printed circuit board (4) by means of the common bearing (5).

## Revendications

1. Module à bornes électrique avec une pluralité d'éléments de contact électrique (3) pour le raccordement de conducteurs électriques, un boîtier (1) pour la réception d'au moins une carte de circuits imprimés (4), sur laquelle est disposé un circuit avec plusieurs composants électriques pour la réalisation d'une fonction prédéterminée, en particulier d'une fonction de temporisation, et des moyens de réglage (2) pour la modification d'au moins une caractéristique électrique du circuit, moyennant quoi au moins une partie du moyen de réglage (2) peut être manipulée à travers une ouverture (13) dans au moins une paroi latérale du boîtier et peut être soumise à un pivotement ou une rotation depuis l'extérieur,
**caractérisé en ce que**
le moyen de réglage (2) est monté, grâce à un support (5), directement sur la carte de circuits imprimés (4).

2. Module à bornes électrique selon la revendication 1,
**caractérisé en ce que**
le montage du moyen de réglage (2) s'effectue grâce à un rivetage et/ou un enclenchement du moyen de réglage (2) dans le support (5) sur la carte de circuits imprimés (4) et/ou grâce à une partie de boîtier formée sur un côté intérieur de boîtier situé en vis-à-vis d'un côté du moyen de réglage.

3. Module à bornes électrique selon l'une des revendications 1 ou 2,
**caractérisé en ce que**
l'on prévoit sur la carte de circuits imprimés (4) des moyens pour supporter le moyen de réglage (2) sur la carte de circuits imprimés (4).

4. Module à bornes électrique selon la revendication 3,
**caractérisé en ce que**
les moyens pour supporter le moyen de réglage (2) sur la carte de circuits imprimés sont formés par une glissière (9) disposée sur la carte de circuits imprimés, dont la géométrie correspond au moins partiellement à la géométrie du moyen de réglage (2).

5. Module à bornes électrique selon l'une des revendications 1 à 4,
**caractérisé en ce que**,
sur la surface du moyen de réglage (2) tournée vers la surface de la carte de circuits imprimés (4), on prévoit des éléments (10, 19), lesquels coopèrent avec des contre-éléments (7, 8; 18) disposés sur la carte de circuits imprimés et/ou à l'intérieur de celle-ci de manière à former entre eux une caractéristique électrique lors de l'amenée d'une tension.

6. Module à bornes électrique selon la revendication 5,
**caractérisé en ce que**
la caractéristique formée entre les éléments du moyen de réglage (10, 19) et les contre-éléments (7, 8; 18) sur la carte de circuits imprimés (4) et/ou à l'intérieur de celle-ci est une résistance électrique, une capacité et/ou une inductance.

7. Module à bornes électrique selon l'une des revendications 5 ou 6,
**caractérisé en ce**
**qu'**il est possible de régler différents trajets de courant grâce aux éléments du moyen de réglage (10, 19) et aux contre-éléments (7, 8; 18) sur la carte de circuits imprimés (4) et/ou à l'intérieur de celle-ci.

8. Module à bornes électrique selon l'une des revendications 5 à 7 précédentes,
**caractérisé en ce que**
l'on obtient, grâce aux éléments du moyen de réglage (10, 19) et aux contre-éléments (7, 8; 18) sur la carte de circuits imprimés (4) et/ou à l'intérieur de celle-ci, une détection optique, capacitive et/ou inductive d'une position relative et/ou absolue du moyen de réglage (2) par rapport à la carte de circuits imprimés (4).

9. Module à bornes électrique selon l'une des revendications 1 à 8,
**caractérisé en ce que**
d'autres éléments sont disposés entre l'arête (17) du moyen de réglage faisant face sur la carte de circuits imprimés et en vis-à-vis de cela sur la carte de circuits imprimés (4), lesquels coopèrent ensemble de manière à former une deuxième caractéristique électrique entre eux lors de l'amenée d'une tension.

10. Module à bornes électrique selon l'une des revendications 1 à 9 précédentes,
**caractérisé en ce que**
des moyens d'enclenchement du moyen de réglage (2) sont disposés sur la carte de circuits imprimés (4) et/ou à l'intérieur de celle-ci selon des espacements prédéterminés.

11. Module à bornes électrique selon l'une des revendications 1 à 10 précédentes,
**caractérisé en ce que**
le moyen de réglage (2) se compose d'un matériau transparent et/ou translucide et **en ce que** l'on prévoit des moyens pour l'éclairage (24) du moyen de réglage sur la carte de circuits imprimés (4) et/ou à l'intérieur de celle-ci.

12. Module à bornes électrique selon l'une des revendications 1 à 11 précédentes,
**caractérisé en ce que**
le moyen de réglage (2) est réalisé en tant que roue sur le pourtour (16) extérieur de laquelle des marquages (11) sont prévus, lesquels permettent un réglage de la caractéristique électrique par pas prédéterminés.

13. Module à bornes électrique selon la revendication 12,
**caractérisé en ce que**
des évidements en forme d'encoche et/ou des saillies (12) sont disposé(e)s entre les marquages (11).

14. Module à bornes électrique selon l'une des revendications 12 ou 13,
**caractérisé en ce que**
les marquages (11) présentent un rapport logique par rapport à la caractéristique électrique respectivement réglée à l'aide du moyen de réglage (2).

15. Module à bornes électrique selon l'une des revendications 1 à 14 précédentes,
**caractérisé en ce que**
des butées pour constater une position de début et/ou de fin du moyen de réglage (2) sont disposées sur la carte de circuits imprimés (4).

16. Module à bornes électrique selon l'une des revendications 1 à 15 précédentes,
**caractérisé en ce que**
le moyen de réglage (2) entoure complètement avec son arête du moyen de réglage (17) les éléments (10, 19) sur le moyen de réglage (2) tout comme également les contre-éléments (7, 8; 18) disposés sur la carte de circuits imprimés (4).

17. Module à bornes électrique selon l'une des revendications 1 à 16 précédentes,
**caractérisé en ce que**
la largeur de construction du boîtier (1) comporte tout au plus 8 mm et/ou est tout au plus une fois et demie aussi grande que la hauteur du moyen de réglage (2).

18. Module à bornes électrique selon l'une des revendications 1 à 17 précédentes,
**caractérisé en ce**
**qu'**un deuxième moyen de réglage (2') est disposé sur le côté de la carte de circuits imprimés (4) situé en vis-à-vis du moyen de réglage (2).

19. Module à bornes électrique selon la revendication 18,
**caractérisé en ce que**
les moyens de réglage (2, 2') sont montés ensemble grâce au support (5) sur des côtés de la carte de circuits imprimés (4) respectivement situés en vis-àvis.
